# EUROPEAN PATENT APPLICATION

(11) **EP 2 757 589 A2**
(43) Date of publication of application: **23.07.2014**
(21) Application number: 14151795.3
(22) Date of filing: 20.01.2014
(51) Int. Cl.: H01L 29/66, H01L 29/786

(54) **Methods for fabricating a thin film transistor and an array substrate**

(30) Priority: 21.01.2013 CN 201310020495
(71) Applicant: Boe Technology Group Co. Ltd., Beijing 100015 (CN); Chengdu BOE Optoelectronics Technology Co., Ltd., Chengdu, Sichuan 611731 (CN)
(72) Inventor: Ni, Shuibin, 100176 Beijing (CN); Wang, Zhen, 100176 Beijing (CN)
(74) Representative: Michalski Hüttermann & Partner Patentanwälte

(57) **Abstract**

The present invention provides methods for fabricating a thin film transistor and an array substrate, which are applicable in the field of display device fabrication, and solve the problem of performing patterning process too many times during the fabrications of a thin film transistor and an array substrate. The method for fabricating a thin film transistor comprises: forming a gate layer on a substrate; forming a gate insulation layer on the substrate; forming an oxide semiconductor layer and a barrier layer and on the substrate; and forming a source-drain layer on the substrate, wherein, the step of forming the oxide semiconductor layer and the barrier layer comprises: sequentially forming an oxide semiconductor film a the barrier film; and forming the oxide semiconductor layer from the oxide semiconductor film and the barrier layer from the barrier film by performing a patterning process once.

## Description

### Field of the Invention

The present invention relates to the field of display technology, and particularly, to a method for fabricating a thin film transistor and a method for fabricating an array substrate.

### Description of the Related Art

Oxide semiconductors which are represented by IGZO (Indium Gallium Zinc Oxide) are widely used in the field of liquid-crystal display because of their properties of high electron mobility and good uniformity, and are materials used for fabricating the channel of a TFT (Thin Film Transistor).

A fabricating procedure of an existing oxide-semiconductor thin-film-transistor array substrate, such as IGZO-TFT (Indium Gallium Zinc Oxide-Thin Film Transistor) array substrate, is as follows: sequentially forming a gate metal layer, a gate insulation layer, an IGZO semiconductor layer, a barrier layer, a source-drain metal layer, a passivation layer and a pixel electrode layer on a substrate. Herein, during each formation of one of the gate metal layer, the IGZO semiconductor layer, the barrier layer, the source-drain metal layer, the passivation layer and the pixel electrode layer, a whole patterning process including steps of deposition, photoresist applying, exposure, developing, etching and peeling is needed, so as to form respective film pattern layer, that is , the exposure step needs to be performed six times, in order to form an IGZO-TFT array substrate. Thus, in conventional methods, the number of times of performing the patterning process is large, and the period of the patterning process is long.

### Summary of the Invention

An objective of the present invention is to provide methods for fabricating a thin film transistor and an array substrate, and these methods can reduce the number of times of performing the patterning process during the fabricating procedure of the thin film transistor and the array substrate.

In order to realize the above objective, embodiments of the present invention provide the following technical solutions:
Embodiments of the invention provide a method for fabricating a thin film transistor, comprising steps of: forming a gate layer on a substrate; forming a gate insulation layer on the substrate; forming an oxide semiconductor layer and a barrier layer on the substrate; and forming a source-drain layer on the substrate, wherein, the step of forming the oxide semiconductor layer and the barrier layer comprises:
   sequentially forming an oxide semiconductor film and a barrier film; and
   forming the oxide semiconductor layer from the oxide semiconductor film and the barrier layer from the barrier film by performing a patterning process once.

Optionally, forming the oxide semiconductor layer and the barrier layer by performing the patterning process once comprises:
coating a photoresist on the substrate where the oxide semiconductor film and the barrier film have been formed;
exposing the photoresist by using a multi-tone mask, and then developing the exposed photoresist so as to form a photoresist completely preserved region, a photoresist partially preserved region and a photoresist completely removed region; wherein, the photoresist completely preserved region corresponds to a channel region of the thin film transistor, the photoresist partially preserved region corresponds to a region where the oxide semiconductor layer is to be formed except for the channel region, and photoresist in the photoresist completely removed region is completely removed;
removing a part of the oxide semiconductor film and a part of the barrier film which are located in the photoresist completely removed region;
performing an ashing process on the photoresist completely preserved region and the photoresist partially preserved region, so that photoresist in the photoresist partially preserved region is removed;
removing a part of the barrier film in the photoresist partially preserved region; and
peeling off the remaining photoresist.

Optionally, the multi-tone mask comprises: a fully transparent region, a semi-transparent region and an opaque region; and
in a case that the photoresist is a positive photoresist, the opaque region corresponds to the photoresist completely preserved region, the semi-transparent region corresponds to the photoresist partially preserved region, and the fully transparent region corresponds to the photoresist completely removed region; or,
in a case that the photoresist is a negative photoresist, the fully transparent region corresponds to the photoresist completely preserved region, the semi-transparent region corresponds to the photoresist partially preserved region, and the opaque region corresponds to the photoresist completely removed region.

Optionally, the multi-tone mask comprises: a mask baseplate and a semi-transparent film;
the mask baseplate comprises: a fully transparent portion and an opaque portion, wherein the fully transparent portion corresponds to the fully transparent region and the semi-transparent region of the multi-tone mask, and the opaque portion corresponds to the opaque region of the multi-tone mask; and
the semi-transparent film is attached onto the mask baseplate, and corresponds to the semi-transparent region of the multi-tone mask.
Optionally, the step of forming the gate layer on the substrate comprises: forming a gate metal film on the substrate; and forming the gate layer from the gate metal film by performing a patterning process once.

Optionally, the step of forming the gate insulation layer on the substrate comprises: forming a gate insulation film on the substrate where the gate layer has been formed so as to cover the gate layer.

Optionally, the step of forming the source-drain layer on the substrate comprises: forming a source-drain metal film on the substrate where the oxide semiconductor layer and the barrier layer have been formed; and forming the source-drain layer from the source-drain metal film by performing a patterning process once, so as to cover the oxide semiconductor layer.

Optionally, a material used for forming the oxide semiconductor layer is indium gallium zinc oxide.

Optionally, a material used for forming the gate layer and/or the source-drain layer is molybdenum.

Embodiments of the present invention provide a method for fabricating an array substrate, which comprises steps of: disposing a thin film transistor on a substrate; and disposing a pixel electrode layer on the substrate where the thin film transistor has been formed, wherein, the step of disposing the thin film transistor on the substrate uses any of the methods for fabricating a thin film transistor provided by the embodiments of the present invention.

The methods for fabricating a thin film transistor and an array substrate provided by the embodiments of the invention could form the oxide semiconductor layer and the barrier layer by performing a patterning process once. Therefore, compared with the situation in the prior art that the patterning processes need to be respectively performed for the formation of the oxide semiconductor layer and the formation of the barrier layer, technical effect of reducing the number of times of performing a patterning process is realized.

### Brief Description of the Drawings

Figure 1 is a top view showing a structure of a pixel unit on an array substrate of the prior art;
Figure 2 is a sectional diagram taken along a line a-a' in Figure 1, schematically showing a structure of a thin film transistor;
Figure 3 is a flow chart of a method for fabricating a thin film transistor provided by an embodiment of the present invention;
Figure 4 is a flow chart of a fabricating method for forming a gate metal film into a gate layer on a substrate;
Figure 5 is a flow chart of a fabricating method for forming an oxide semiconductor film and a barrier film into an oxide semiconductor layer and a barrier layer by performing a patterning process once according to an embodiment of the present invention.
Figure 6 is a schematic diagram showing a structure after a photoresist is coated on the oxide semiconductor film and the barrier film, during the fabrication of the thin film transistor shown in Figure 2;
Figure 7 is a schematic diagram showing a structure after the photoresist of Figure 6 is developed, during the fabrication of the thin film transistor shown in Figure 2;
Figure 8 is a schematic diagram showing a structure after a part of oxide semiconductor film and a part of barrier film which are located in a photoresist completely removed region are removed from the structure of Figure 7, during the fabrication of the thin film transistor shown in Figure 2;
Figure 9 is a schematic diagram showing a structure after an ashing process is performed on the photoresist in the structure of Figure 8, during the fabrication of the thin film transistor shown in Figure 2;
Figure 10 is a schematic diagram showing a structure after a part of barrier film in the photoresist partially preserved region is removed from the structure of Figure 9, during the fabrication of the thin film transistor shown in Figure 2;
Figure 11 is a schematic diagram showing a structure after the photoresist is peeled off from the structure of Figure 10, during the fabrication of the thin film transistor shown in Figure 2;
Figure 12 is a sectional diagram taken along the line a-a' in Figure 1 schematically showing a structure of an array substrate, which only shows a region corresponding to a TFT and partial pixel electrode region; and
Figure 13 shows a method for fabricating an array substrate provided by an embodiment of the present invention.

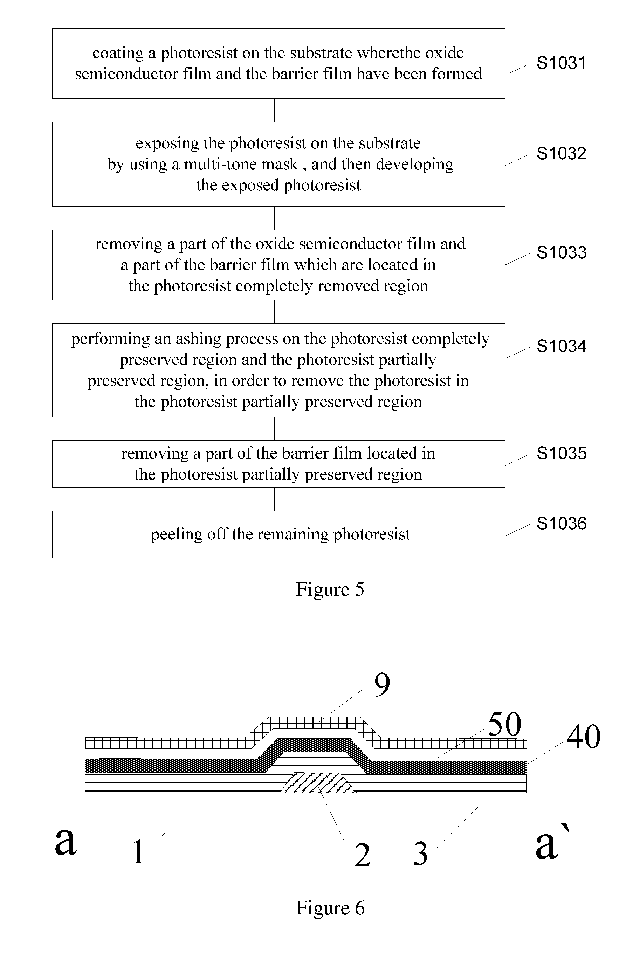

Description of reference numerals:
1-substrate; 2-gate layer; 3-gate insulation layer; 4-oxide semiconductor layer;
   5-barrier layer; 6-source-drain layer; 7-passivation layer; 8-pixel electrode layer; 9-photoresist (in Figures 6 - 10, all states of photoresist are labeled by the numeral "9"); 10-gate line; 11-data line; 40-oxide semiconductor film; 50-barrier film; 51-first barrier pattern; 61-drain; 62-source; 100-thin film transistor.

### Detailed Description Of the Preferred Embodiments

In the following, technical solutions in embodiments of the present invention will be clearly and thoroughly described in combination with the accompanying figures in the embodiments of the present invention; obviously, embodiments to be described are only parts of the embodiments of the present invention, but not all embodiments.

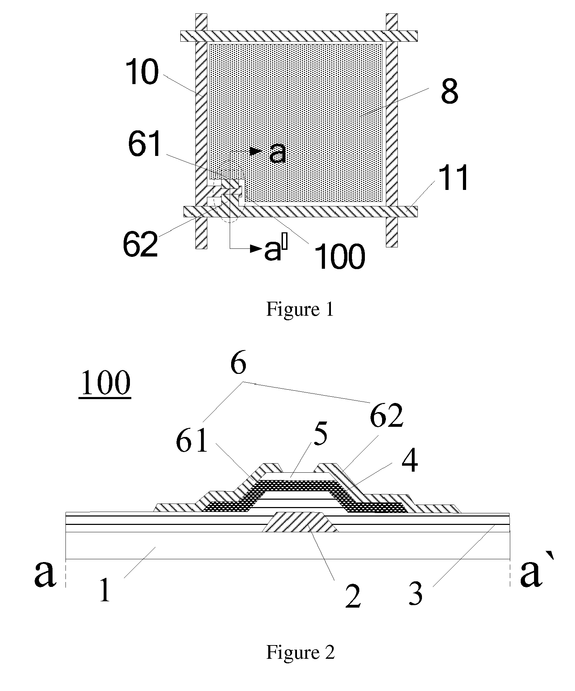

Figure 1 shows a top view of an existing array substrate. Figure 2 shows a sectional diagram taken along a line a-a' in Figure 1, schematically showing a thin film transistor 100 on an array substrate. As shown in Figures 1 and 2, the thin film transistor 100 comprises: a gate layer 2 provided on a substrate 1; a gate insulation layer 3 covering the gate layer 2; an oxide semiconductor layer 4 located on the gate insulation layer 3; a barrier layer 5 located on and partially covering the oxide semiconductor layer 4; and a source-drain layer 6 which is located above the oxide semiconductor layer 4 and the barrier layer 5 and covers a part of the oxide semiconductor layer 4 which is not covered by the barrier layer 5 as well as both ends of the barrier layer 5; the source-drain layer 6 comprises a drain 61, located at one end of the oxide semiconductor layer 4 and barrier layer 5, and a source 62 at another end. A method for fabricating a thin film transistor provided by the embodiments of the present invention is described in the following; however, the present invention is not limited to the thin film transistors shown in the figures.

The embodiment of the present invention provides a method for fabricating a thin film transistor, comprising steps of: forming the gate layer on the substrate; forming the gate insulation layer so as to cover the gate layer; forming the oxide semiconductor layer and the barrier layer; and forming the source-drain layer on the oxide semiconductor layer and the barrier layer. Wherein, the step of forming the oxide semiconductor layer and the barrier layer comprises:
sequentially forming an oxide semiconductor film and a barrier film; and
forming the oxide semiconductor layer from the oxide semiconductor film and the barrier layer from the barrier film by performing a patterning process once.

Herein, the substrate is a transparent substrate. The material used for forming the oxide semiconductor layer may be IGZO, MIZO (Mg-In-Zn-O, magnesium-indium-zinc-oxygen), or the like. The embodiments of the present invention are described in details by taking IGZO as an example of the material of the oxide semiconductor. The material used for forming the barrier layer may be SiO₂ (silicon dioxide). The material used for forming the gate layer and the source-drain layer may be a conductive material such as a metal. The embodiments of the present invention is described in details by taking molybdenum as an example of the material of the gate layer and the source-drain layer.

In all embodiments of the present invention, definitions of "film", "layer" and "pattern" as well as their relationship will be clarified as follows. Hereinafter, "film" refers to a layer of film fabricated by disposing a certain material on a substrate through a deposition process or other process. If no patterning process needs to be performed on such "film" during the whole fabrication procedure, then such "film" may also be called as "layer". If a patterning process needs to be performed on such "film" during the whole fabrication procedure, then it is called as "film" before the patterning process, and is called as "layer" after the patterning process. At least one film "pattern" is included in the "layer" subjected to a patterning process.

For example, a material of the gate insulation layer may be SiNₓ (silicon nitride). Usually, no patterning process needs to be performed on the gate insulation layer. For example, the oxide semiconductor layer is formed by performing a patterning process on the oxide semiconductor film, and the barrier layer is formed by performing a patterning process on the barrier film. Both the gate layer and the source-drain layer are patterns.

So-called "patterning process" is a process for forming a layer including at least one pattern from a film; and the patterning process usually includes: coating a photoresist on the film, exposing the photoresist by using a mask, removing part of the photoresist that needs to be removed by using a developer, then etching a part of the film that is not covered by the photoresist, and finally peeling off the remaining photoresist. In all embodiments of the present invention, the "one patterning process" means that exposure is performed only once during the patterning process.

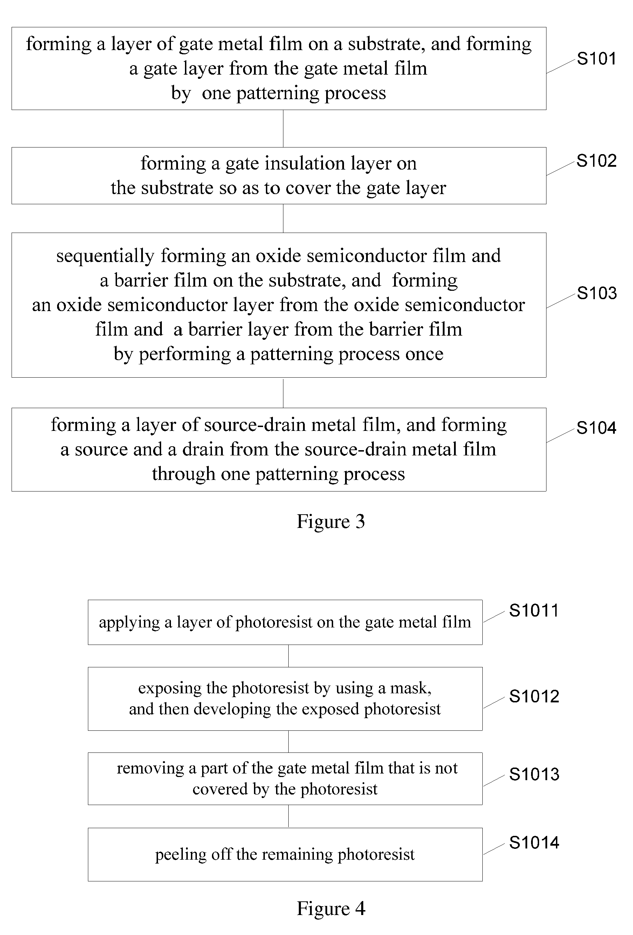

In the following, a specific embodiment will be provided to describe a fabricating procedure of the thin film transistor 100 in details. As shown in Figure 3, a method for fabricating the thin film transistor 100 comprises steps of:
S101, forming a layer of gate metal film on a substrate, and forming a gate layer from the gate metal film by performing a patterning process once.

Specifically, a material of the gate film preferably is molybdenum; a film is formed preferably through a deposition process, with which the gate metal film is formed on the substrate; and the gate layer is formed through one time exposure process or the like.

S102, on the substrate with the gate layer formed thereon, forming a gate insulation layer which covers the gate layer.

Specifically, a layer of insulating material is formed on the substrate with the gate layer formed thereon, preferably by means of deposition process, so as to form the gate insulation layer; and the gate insulation layer has a function of electrical insulation.

S103, sequentially forming an oxide semiconductor film and a barrier film on the substrate where the gate insulation layer has been formed, and forming an oxide semiconductor layer from the oxide semiconductor film and a barrier layer from the barrier film by performing a patterning process once.

Specifically, a layer of oxide semiconductor film is formed on the substrate with the gate layer and the gate insulation layer formed thereon, preferably by means of deposition process; subsequently, a layer of barrier film is formed on the oxide semiconductor film, preferably by means of deposition process; and then the oxide semiconductor layer and the barrier layer are formed through one patterning process. Herein, the oxide semiconductor layer is used as an active layer; the barrier layer is used as an etch stop layer, for avoiding influence on the oxide semiconductor layer when metal layers above the oxide semiconductor layer are etched in subsequent processes, and also for avoiding changes of property of the thin film transistor caused by reactions between the oxide semiconductor layer and oxygen or water in the air when the oxide semiconductor layer is exposed to the air. Here, description is made by taking an IGZO film as an example of the oxide semiconductor film.

S104, forming a layer of source-drain metal film, and then forming a source-drain layer from the source-drain metal film by performing a patterning process once, so as to cover the oxide semiconductor layer.

Specifically, a material used for forming the source-drain metal film preferably is molybdenum. Preferably, the layer of the source-drain metal film is formed by means of deposition process on the substrate where the oxide semiconductor layer and the barrier layer have been formed; and the source-drain layer is formed through one time exposure process and the like. As shown in Figure 2, the source 62 and the drain 61 included in the formed source-drain layer 6 each cover a part of the oxide semiconductor layer 4 that is not covered by the barrier layer 5 and one end of the barrier layer 5.

Obviously, a PVX layer (i.e. the passivation layer) may also be formed on the substrate so as to cover the source-drain layer and the exposed portion of the barrier layer.

The method for fabricating a thin film transistor provided by the above embodiment simply uses one patterning process to form the oxide semiconductor layer and the barrier layer, thus, compared with the situation in the prior art that patterning processes need to be respectively performed for the formation of the oxide semiconductor layer and the formation of the barrier layer, technical effect of reducing the number of times of performing the patterning process is realized.

Specifically, Figure 4 shows a preferable implementation of "forming the gate layer from the gate metal film by performing the patterning process once" in the above step S101, which includes the following steps S1011 to S1014:
S1011, applying a layer of photoresist on the gate metal film.

Wherein, photoresists are divided into positive photoresists and negative photoresists. Those generate insoluble substance after being irradiated by light is negative photoresists; on the contrary, those become into soluble substance after being irradiated by light are positive photoresists. Herein, "soluble" and "insoluble" are defined in relative to specific developers. The embodiments of the present invention are described in details by taking positive photoresist as an example.

S1012, exposing the photoresist by using a mask, and then developing the exposed photoresist.

Specifically, the mask may be a normal mask comprising transparent regions and opaque regions. As for a positive photoresist, photoresist in regions where light irradiation has occurred through the transparent regions forms soluble substance; photoresist in regions where light irradiation has not occurred forms insoluble substance. Then, developer can be used to develop the photoresist, and part of photoresist that needs to be removed is then removed. Herein, the photoresist that needs to be removed is the photoresist that does not correspond to the gate layer. Specifically, developer is used to remove the photoresist located in the region that has been irradiated by light, while the photoresist located in the region that has not been irradiated by light remains.

S1013, removing a part of the gate metal film that is not covered by the photoresist.

Specifically, an etchant may be used to etch the part of the gate metal film that is not covered by the photoresist.

S1014, peeling off the remaining photoresist.

Therefore, the photoresist is peeled off, and the gate layer is formed on the substrate.

Specifically, Figure 5 shows a preferable implementation of "forming the oxide semiconductor layer and the barrier layer by performing the patterning process once" in the above step S103, which includes the following steps S1031 to S1036:
S1031, coating a photoresist on the substrate where the oxide semiconductor film and the barrier film have been formed.

Preferably, a layer of oxide semiconductor film is formed on the gate insulation layer by means of deposition process, then a layer of barrier film is deposited on the oxide semiconductor film, and a layer of photoresist is coated on the barrier film. As shown in Figure 6, the oxide semiconductor film 40 and the barrier film 50 are coated with a layer of photoresist 9.

S1032, exposing the photoresist on the substrate by using a multi-tone mask, and then developing the exposed photoresist.

Here, since only one patterning process is required to pattern the two layers of films, the multi-tone mask may preferably be a half-grey or half-tone mask. Developer may be used to develop the photoresist exposed by using the half-grey or half-tone mask, and a photoresist completely preserved region, a photoresist partially preserved region and a photoresist completely removed region are formed after developing.

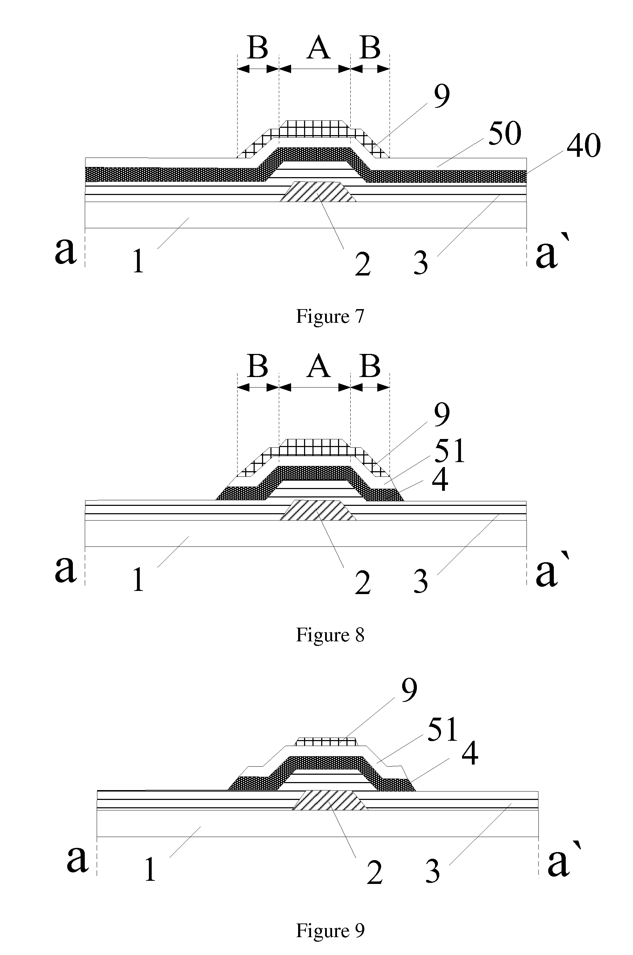

Herein, as shown in Figure 7, region A is the photoresist completely preserved region, which corresponds to the channel region of the thin film transistor; and thickness of the photoresist in this region should be as uniform as possible, which equals to the original thickness of the photoresist when the coating is completed. Region B is the photoresist partially preserved region, which corresponds to a region where the oxide semiconductor layer is to be formed except for the channel region; and thickness of the photoresist in this region should also be as uniform as possible, which is smaller than the original thickness of the photoresist when the coating is completed; preferably, the thickness of the photoresist in this region may be but not limited to half of the original thickness. Regions other than regions A and B are the photoresist completely removed region, wherein the photoresist is completely removed.

As an optional implementation, the half-grey or half-tone mask includes: a fully transparent region, a semi-transparent region and an opaque region. Further, preferable, the half-grey or half-tone mask includes a mask baseplate and a semi-transparent film. Herein, the mask baseplate includes a fully transparent portion and an opaque portion. The fully transparent portion corresponds to the fully transparent region and the semi-transparent region of the half-grey or half-tone mask; the opaque portion corresponds to the opaque region of the half-grey or half-tone mask. The semi-transparent film is attached onto the mask baseplate, and corresponds to the semi-transparent region of half-grey or half-tone mask.

Herein, if the photoresist is a positive photoresist, the opaque region of the half-grey or half-tone mask corresponds to the photoresist completely preserved region; the semi-transparent region corresponds to the photoresist partially preserved region; the fully transparent region corresponds to the photoresist completely removed region. If the photoresist is a negative photoresist, the fully transparent region of the half-grey or half-tone mask corresponds to the photoresist completely preserved region; the semi-transparent region corresponds to the photoresist partially preserved region; the opaque region corresponds to the photoresist completely removed region. The embodiments of the invention are described by taking a positive photoresist as an example.

S1033, removing a part of the oxide semiconductor film and a part of the barrier film which are located in the photoresist completely removed region.

As shown in Figure 8, specifically, an etchant may be used to etch a part of the oxide semiconductor film 40 and a part of the barrier film 50 which are not covered by the photoresist, so as to form the oxide semiconductor layer 4 from the oxide semiconductor film, and form the first barrier pattern 51 from the barrier film.

S1034, performing an ashing process on the photoresist completely preserved region and the photoresist partially preserved region, in order to remove the photoresist in the photoresist partially preserved region.

As shown in Figure 9, wherein, the "ashing process" means thinning the entire photoresist, so that the photoresist in the photoresist partially preserved region is completed removed, while the photoresist in the photoresist completely preserved region still remains with a certain thickness.

S1035, removing a part of the barrier film located in the photoresist partially preserved region.

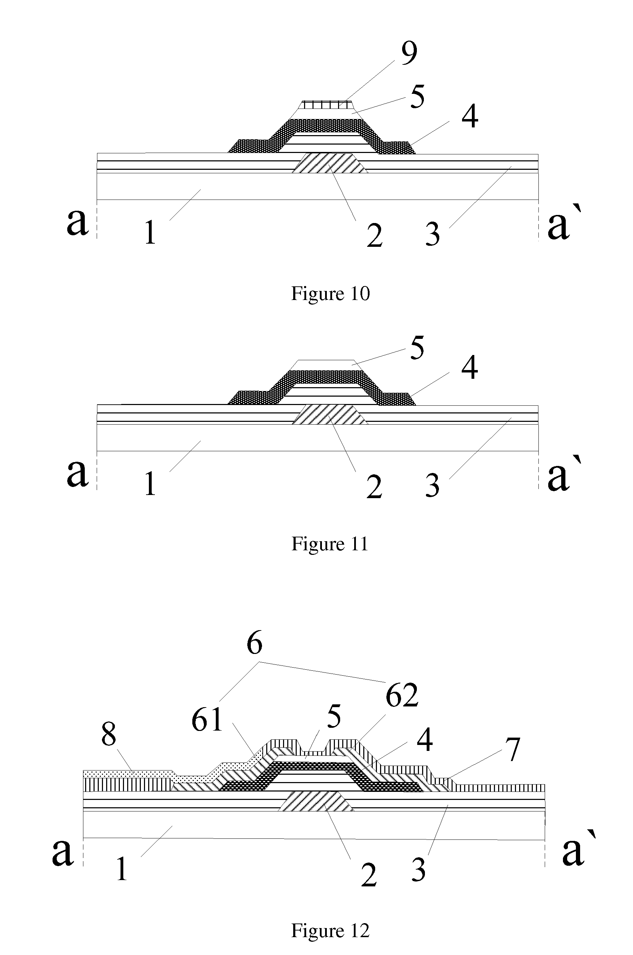

As shown in Figure 10, an etchant may be used to etch a part of the barrier film of the first barrier pattern 51, which corresponds the photoresist partial preserved region, i.e., to etch the part which is not covered by the photoresist, so as to form the barrier layer 5.

S1036, peeling off the remaining photoresist.

As shown in Figure 11, the remaining photoresist is peeled off, so as to expose the barrier layer 5.

In the above embodiment, by completely preserving the photoresist corresponding to the channel region in S1032, and partially preserving the photoresist corresponding to the oxide semiconductor region except for the channel region, and in combination with layered removing of the photoresist realized by the ashing process in subsequent processes, the barrier layer and the oxide semiconductor with different shapes are respectively formed. Thus, objective of forming the oxide semiconductor layer and the barrier layer only through one patterning process is realized; thus, the number of times of performing exposure by using a mask is reduced, and the fabricating cost is significantly saved.

Current display devices at least comprises: organic light emitting displays (OLEDs) and liquid-crystal display devices. Herein, a liquid-crystal display device uses electric field to control light transmission through liquid crystals, so as to display images. Based on directions in which electric fields drive liquid crystals, the liquid-crystal display devices can be roughly divided into vertical electric field driving type and horizontal electric field driving type. A vertical electric field driving type liquid-crystal display device disposes common electrodes and pixel electrodes opposite to each other on upper and lower substrates, and vertical electric fields are formed between the common electrodes and the pixel electrodes so as to drive liquid crystals, such as a TN (Twist Nematic) type liquid-crystal display device or a VA (Vertical Alignment) type liquid-crystal display device. A horizontal electric field driving type liquid-crystal display device disposes the common electrodes and the pixel electrodes on the lower substrate, and horizontal electric fields are formed between the common electrodes and the pixel electrodes so as to drive liquid crystals, such as a ADS (Advanced-Super Dimensional Switching) type liquid-crystal display device or a IPS (In Plane Switch) type liquid-crystal display device.

As for any of the above display devices, it comprises an array substrate; and the array substrate includes a structure of a thin film transistor and a pixel electrode layer. Therefore, the present invention applies to a fabricating procedure of any display device.

Methods provided by the present invention and devices fabricated by the methods may apply to any of the above display devices, and any other device that includes a thin film transistor array substrate.

Embodiments of the present invention provides a method for fabricating an array substrate, comprising: a step of disposing a thin film transistor on a substrate, and a step of disposing a pixel electrode layer on the substrate with the thin film transistor formed thereon; wherein, the step of disposing the thin film transistor on the substrate uses any of the methods for fabricating a thin film transistor provided by the embodiments of the present invention.

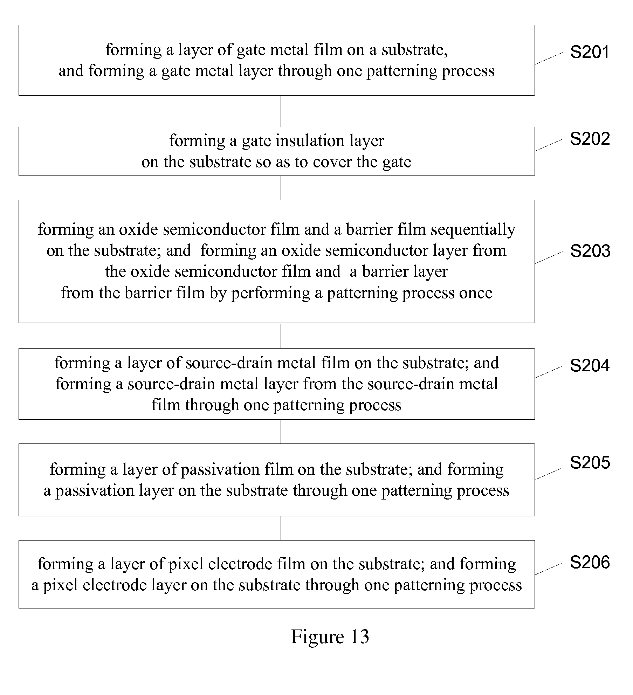

The embodiments of the present invention are described in details by taking an array substrate in a TN type or VA type liquid-crystal display device as an example. As shown in Figures 1 and 12, the array substrate includes the thin film transistor 100, and also includes gate lines 10, data lines 11, and a pixel electrode layer 8. Herein, the gate lines and the gate are disposed in the same layer-level, and are patterns of the gate metal layer; the data lines, the source and the drain are disposed in the same layer-level, and are patterns of the source-drain metal layer. Of course, patterns such as common electrode line and the like also need to be disposed on the array substrate, however, as the patterns such as common electrode line and the like are not related to the inventive point of the present invention, formations of these patterns are not limited and can refer to the prior art, and description thereof is thus omitted. As shown in Figure 13, the method for fabricating an array substrate specifically comprises:

S201, forming a layer of gate metal film on a substrate, and forming a gate metal layer from the gate metal film by performing a patterning process once.

Preferably, molybdenum is deposited on the substrate preferably by means of deposition process, so as to form the gate metal film; and the gate metal layer which includes the gate and the gate lines are formed through one time exposure process and the like. Herein, the gate is connected to a gate line.

S202, forming a gate insulation layer on the substrate so as to cover the gate metal layer.

Specifically, a layer of insulating material is formed on the substrate where the gate metal layer has been formed, preferably by means of deposition process, so as to form the gate insulation layer. The gate insulation layer has a function of electrical insulation.

S203, forming an oxide semiconductor film and a barrier film sequentially on the substrate where the gate insulation layer has been formed; and forming an oxide semiconductor layer from the oxide semiconductor film and a barrier layer from the barrier film by performing a patterning process once.

Specifically, the oxide semiconductor film and the barrier film are sequentially formed on the gate insulation layer preferably by means of deposition process. The method of forming the oxide semiconductor layer from the oxide semiconductor film and the barrier layer from the barrier film through one patterning process may refer to the above steps S1031 to S1036.

S204, forming a layer of source-drain metal film on the substrate ; and forming the source-drain metal layer from the source-drain metal film through one patterning process, so as to cover the oxide semiconductor layer.

Specifically, a material used for forming the source-drain metal film preferably is molybdenum. Further, the layer of source-drain metal film is formed on the substrate where the oxide semiconductor layer and the barrier layer have been formed, preferably by means of deposition process; and the source-drain metal layer is formed through one time exposure process and the like. The source-drain metal layer includes data lines, a source and a drain; wherein, the source is connected to a data line, and the drain is connected to the pixel electrode layer which will be described later. As shown in Figure 12, the source 62 and the drain 61 each cover a part of the oxide semiconductor layer 4 which is not covered by the barrier layer 5 and a part of the barrier layer 5 at one end.

S205, forming a layer of passivation film on the substrate, and forming a passivation layer 7 from the passivation film through one patterning process.

Herein, a material used for forming the passivation film may be SiNₓ (silicon nitride). Specifically, on the substrate where the source-drain metal layer has been formed, a layer of SiNₓ film is formed preferably by a deposition process, and the passivation layer is formed through one time exposure other process and the like.

S206, forming a layer of pixel electrode film on the substrate, and forming a pixel electrode layer from the pixel electrode film through one patterning process.

A material used for forming the pixel electrode film may be ITO (indium tin oxide). Specifically, on the substrate where the passivation layer has been formed, a layer of indium tin oxide film is formed preferably by a deposition process, and the pixel electrode layer (for example, the pixel electrode layer 8 shown in Figures 1 and 12) is formed through one time exposure process and the like.

Since the inventive aspect of the present invention is forming the oxide semiconductor layer and the barrier layer through one patterning process; fabricating methods of other layers, such as methods of forming the gate metal layer, the gate insulation layer, the source-drain metal layer, the passivation layer and the pixel electrode layer on the substrate, are the same as those in the prior art, thus simply refer to the prior art, and will not be described in the embodiments of the present invention.

As for an ADS type or IPS type liquid-crystal display device, its array substrate is also provided with common electrodes thereon, and therefore, the above method also comprises a step of forming the common electrodes on the substrate. Specifically, As for an array substrate of a ADS type liquid-crystal display device, the common electrodes may be disposed on the pixel electrodes; and in this case, after the pixel electrodes have been formed, a common electrode film is formed on the substrate with the pixel electrodes formed thereon, then the common electrode film is formed into the common electrodes through one patterning process. As for an IPS type liquid-crystal display device, the common electrodes may be located in the same layer-level as the pixel electrodes; in this case, while forming the pixel electrodes on the substrate, the pixel electrodes and the common electrodes may be formed through one time exposure process and the like synchronously.

For any kind of array substrate" during the fabricating procedure of the array substrate, the oxide semiconductor layer and the barrier layer are formed by performing the patterning process once; thus, compared with the prior art, the number of times of performing patterning is reduced, fabricating period is shortened, and fabricating cost is saved.

Descriptions above are only specific embodiments of the present invention; however, the protection scope of the present invention is not limited thereto. Modifications and replacements that the person skilled in the art can easily envisage within the scope of technologies disclosed in the present invention fall into the protection scope of the present invention. Therefore, the protection scope of the present invention is defined by the protection scope of the claims.

## Claims

1. A method for fabricating a thin film transistor, comprising steps of: forming a gate layer on a substrate; forming a gate insulation layer on the substrate; forming an oxide semiconductor layer and a barrier layer and on the substrate; and forming a source-drain layer on the substrate, wherein, the step of forming the oxide semiconductor layer and the barrier layer comprises:
sequentially forming an oxide semiconductor film a the barrier film; and
forming the oxide semiconductor layer from the oxide semiconductor film and the barrier layer from the barrier film by performing a patterning process once.

2. A method according to claim 1, wherein, forming the oxide semiconductor layer and the barrier layer by performing the patterning process once comprises:
coating a photoresist on the substrate where the oxide semiconductor film and the barrier film have been formed;
exposing the photoresist by using a multi-tone mask, and then developing the exposed photoresist so as to form a photoresist completely preserved region, a photoresist partially preserved region and a photoresist completely removed region; wherein, the photoresist completely preserved region corresponds to a channel region of the thin film transistor, the photoresist partially preserved region corresponds to a region where the oxide semiconductor layer is to be formed except for the channel region, and photoresist in the photoresist completely removed region is completely removed;
removing a part of the oxide semiconductor film and a part of the barrier film which are located in the photoresist completely removed region;
performing an ashing process on the photoresist completely preserved region and the photoresist partially preserved region, so that photoresist in the photoresist partially preserved region is removed;
removing a part of the barrier film located in the photoresist partially preserved region; and
peeling off remaining photoresist.

3. A method according to claim 2, wherein, the multi-tone mask comprises: a fully transparent region, a semi-transparent region and an opaque region; and
in a case that the photoresist is a positive photoresist, the opaque region corresponds to the photoresist completely preserved region, the semi-transparent region corresponds to the photoresist partially preserved region, and the fully transparent region corresponds to the photoresist completely removed region; or,
in a case that the photoresist is a negative photoresist, the fully transparent region corresponds to the photoresist completely preserved region, the semi-transparent region corresponds to the photoresist partially preserved region, and the opaque region corresponds to the photoresist completely removed region.

4. A method according to claim 3, wherein, the multi-tone mask comprises: a mask baseplate and a semi-transparent film;
the mask baseplate comprises: a fully transparent portion and an opaque portion, wherein the fully transparent portion corresponds to the fully transparent region and the semi-transparent region of the multi-tone mask, and the opaque portion corresponds to the opaque region of the multi-tone mask; and
the semi-transparent film is attached onto the mask baseplate, and corresponds to the semi-transparent region of the multi-tone mask.

5. A method according to any of claims 1 to 4, wherein, the step of forming the gate layer on the substrate comprises:
forming a gate metal film on the substrate; and
forming the gate layer from the gate metal film by performing a patterning process once.

6. A method according to any of claims 1 to 5, wherein, the step of forming the gate insulation layer on the substrate comprises: forming a gate insulation film on the substrate where the gate layer has been formed, so as to cover the gate layer.

7. A method according to any of claims 1 to 6, wherein, the step of forming the source-drain layer on the substrate comprises:
forming a source-drain metal film on the substrate where the oxide semiconductor layer and the barrier layer have been formed; and
forming the source-drain layer from the source-drain metal film by performing a patterning process once, so as to cover the oxide semiconductor layer.

8. A method according to any of claims 1 to 7, wherein, a material used for forming the oxide semiconductor layer is indium gallium zinc oxide.

9. A method according to any of claims 1 to 8, wherein, a material used for forming the gate layer and/or the source-drain layer is molybdenum.

10. A method for fabricating an array substrate, comprising steps of: disposing a thin film transistor on a substrate; and disposing a pixel electrode layer on the substrate where the thin film transistor has been formed, wherein, the step of disposing the thin film transistor on the substrate uses the method for fabricating a thin film transistor according to any one of claims 1-9.
